# EUROPEAN PATENT APPLICATION

(11) **EP 4 421 561 A1**
(43) Date of publication of application: **28.08.2024**
(21) Application number: 22891551.8
(22) Date of filing: 15.08.2022
(51) Int. Cl.: G03B 17/12

(54) **CIRCUIT BOARD REINFORCING STRUCTURE, PHOTOSENSITIVE DEVICE, AND TERMINAL**

(30) Priority: 12.11.2021 CN 202111340931
(71) Applicant: Huawei Technologies Co., Ltd., Shenzhen, Guangdong 518129 (CN)
(72) Inventor: LIU, Jun, Shenzhen, Guangdong 518129 (CN); LU, Zuomin, Shenzhen, Guangdong 518129 (CN); LI, Tianyu, Shenzhen, Guangdong 518129 (CN)
(74) Representative: Körber, Martin Hans
(86) International application number: PCT/CN2022/112508
(87) International publication number: WO 2023/082743

(57) **Abstract**

This application provides a circuit board reinforcing structure, a photosensitive apparatus, and a terminal. The photosensitive apparatus may be used in assisted driving, intelligent driving, or autonomous driving. In the circuit board reinforcing structure, a reinforcing plate of which deformation varies little with temperature is used to suppress warping and deformation of a circuit board caused by a temperature change, so that an impact of the warping and deformation of the circuit board on a location of a photosensitive chip is greatly reduced. In addition, the reinforcing plate and the photosensitive chip are disposed on a same side of the circuit board, so that when the circuit board reinforcing structure is used in the photosensitive apparatus, a wire can be conveniently led out from the circuit board without disposing an additional structure for wiring on the reinforcing plate. Further, the photosensitive apparatus including the circuit board reinforcing structure in this application and the terminal have same effect.

## Description

This application claims priority to Chinese Patent Application No. 202111340931.2, filed with the China National Intellectual Property Administration on November 12, 2021 and entitled "CIRCUIT BOARD REINFORCING STRUCTURE, PHOTOSENSITIVE APPARATUS, AND TERMINAL", which is incorporated herein by reference in its entirety.

### TECHNICAL FIELD

This application relates to a technology for strengthening strength of a circuit board structure, and in particular, to a circuit board reinforcing structure, a photosensitive apparatus, and a terminal.

### BACKGROUND

Currently, a camera module is widely used as one of basic sensors of a vehicle. As the camera module is a precise imaging component, there is a very strict requirement on a shape and a location of a core component (for example, a photosensitive chip). Generally, a small change in the shape and the location of the core component may cause a decline in imaging quality of the camera module. The foregoing problem is usually caused by a change in temperature of a working environment of the camera module. Specifically, because a circuit board on which the photosensitive chip is disposed is usually formed by pressing a plurality of layers (such as conductor wire layers and resin layers) in a stacked and alternate manner, material density and composition of each of the layers of the circuit board are different, and when the temperature of the working environment of the camera module changes, the circuit board is prone to getting warped and deformed. When the circuit board is warped and deformed, an image surface of a lens of the camera module is separated from a photosensitive surface of the photosensitive chip, resulting in the decline in imaging quality of the lens of the camera mold. In the field of camera modules, this phenomenon is usually referred to as temperature drift, and temperature drift suppression is one of key problems to be resolved for the camera module. A person skilled in the art provides different solutions.

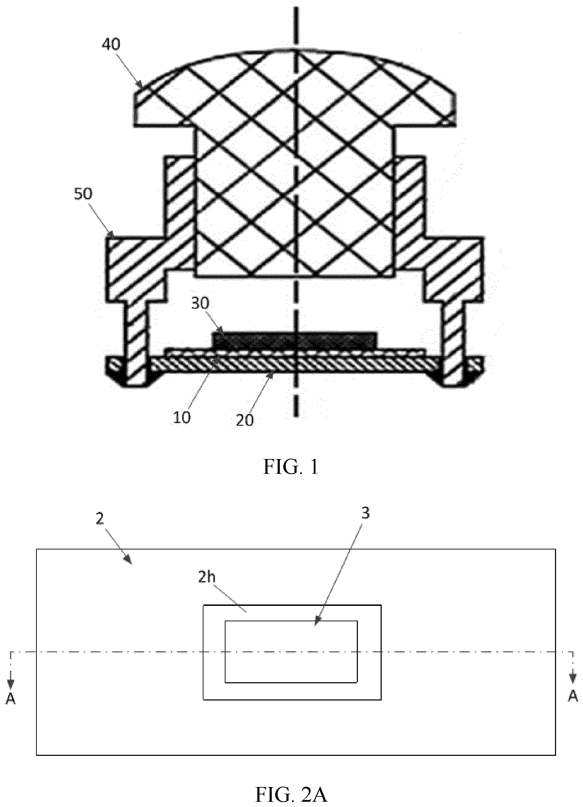

In one solution, the temperature drift is suppressed by disposing a reinforcing plate. Specifically, as shown in FIG. 1, the camera module includes a flexible circuit board 10, a reinforcing plate 20, a photosensitive chip 30, a lens 40, and a holder 50 that are assembled together. The photosensitive chip 30 is disposed on the flexible circuit board 10 and is electrically connected to the flexible circuit board 10. The flexible circuit board 10 is fastened to the reinforcing plate 20 made of metal. The photosensitive chip 30 and the reinforcing plate 20 are respectively disposed on two sides of the flexible circuit board 10. A hole is provided on a periphery of the reinforcing plate 20, and a pin of the holder 50 is inserted into the hole and is fastened to the reinforcing plate 20 by using glue. The lens 40 is disposed in the holder 50 by using a threaded joint or glue, and an image surface of the lens 40 coincides with a photosensitive surface of the photosensitive chip 30. In this way, because the reinforcing plate 20 made of metal deformed slightly when the temperature of the working environment of the camera module changes, warping and deformation of the flexible circuit board 10 fastened to the reinforcing plate 20 are suppressed, thereby suppressing the foregoing phenomenon of temperature drift. However, in the foregoing solution, because the photosensitive chip 30 needs to receive light passing through the lens 40 to implement imaging, the flexible circuit board 10 and the photosensitive chip 30 that are disposed on a same side of the reinforcing plate 20 need to be opposite to the lens 40. Therefore, a lead wire of the flexible circuit board 10 needs to pass through an additional structure, such as a hole or a groove provided on the reinforcing plate 20, to arrange the lead wire of the flexible circuit board 10. This causes inconvenience to processing and assembly of the entire camera module. In addition, the foregoing camera module uses the flexible circuit board 10, resulting in high costs of the camera module.

### SUMMARY

In view of this, a circuit board reinforcing structure, a photosensitive apparatus, and a terminal are provided. The circuit board reinforcing structure, the photosensitive apparatus, and the terminal not only can suppress warping and deformation of a circuit board of a circuit board assembly caused by a temperature change with a simple structure to reduce an adverse impact caused by the warping and deformation on a photosensitive chip, but also can conveniently perform wiring on a lead wire of the circuit board.

Therefore, the following technical solutions are used in this application.

According to a first aspect, an embodiment of this application provides a following circuit board reinforcing structure, and the circuit board reinforcing structure is used in a circuit board assembly.

The circuit board assembly includes a circuit board and a photosensitive chip, the circuit board includes a first surface and a second surface that are opposite to each other, and the photosensitive chip is disposed on the first surface of the circuit board and is electrically connected to the circuit board.

The circuit board reinforcing structure includes a reinforcing plate, the reinforcing plate includes a third surface and a fourth surface that are opposite to each other, the reinforcing plate and the circuit board are fastened to each other, and the third surface and the first surface are in surface contact, so that both the reinforcing plate and the photosensitive chip are located on a side on which the first surface of the circuit board is located.

According to foregoing technical solution, because the reinforcing plate that is in surface contact with the circuit board is disposed, warping and deformation of the circuit board of the circuit board assembly caused by a temperature change can be suppressed with a simple structure, and an adverse impact caused by the warping and deformation on the photosensitive chip can be reduced. Because the photosensitive chip and the reinforcing plate are located on a same side of the circuit board, wiring can be conveniently performed on a lead wire of the circuit board without disposing an additional structure such as a hole or a groove on the reinforcing plate when the circuit board assembly having the circuit board reinforcing structure is disposed in a photosensitive apparatus. In addition, the foregoing structure has strong manufacturability, and can reduce manufacturing difficulty in a technology.

In a possible implementation of the first aspect, a slot is provided on the reinforcing plate, and the photosensitive chip is located in the slot.

According to the foregoing technical solution, interference between the reinforcing plate and the photosensitive chip is prevented when the reinforcing plate and the photosensitive chip are disposed on the circuit board and located on the same side of the circuit board.

In a possible implementation of the first aspect, a shape of the slot is geometrically similar to a shape of an outer contour of the photosensitive chip.

According to the foregoing technical solution, compared with a case in which the shape of the slot is not geometrically similar to the shape of the outer contour of the photosensitive chip, a contact area between the circuit board and the reinforcing plate can be as large as possible. Therefore, a capability of the reinforcing plate to suppress the warping and deformation of the circuit board is improved.

In a possible implementation of the first aspect, both the shape of the slot and the shape of the outer contour of the photosensitive chip are rectangular, and a size of the slot is greater than a size of the outer contour of the photosensitive chip, so that a gap exists between a periphery of the slot and the outer contour of the photosensitive chip.

The foregoing technical solution helps position the photosensitive chip in the slot.

In a possible implementation of the first aspect, the reinforcing plate and the circuit board are fastened to each other in at least one of the following manners: bonded to each other by using an adhesive, fastened by using a threaded connection member, fastened to each other by soldering, and fastened to each other in an integrally formed manner.

According to the foregoing technical solution, the reinforcing plate and the circuit board can be fastened to each other in different fastening manners for different scenarios.

In a possible implementation of the first aspect, the photosensitive chip is electrically connected to the circuit board through a solder joint.

According to the foregoing technical solution, the photosensitive chip can be electrically connected to the circuit board in a stable and effective manner.

According to a second aspect, an embodiment of this application provides a following photosensitive apparatus. The photosensitive apparatus includes the circuit board reinforcing structure according to any one of the foregoing technical solutions.

According to the foregoing technical solution, an application scenario to which the circuit board reinforcing structure according to this application is applicable is provided.

In a possible implementation of the second aspect, the photosensitive apparatus further includes a circuit board assembly, a holder, and an optical system configured to collect light, the optical system and the reinforcing plate are fastened to the holder, an optical axis of the optical system is perpendicular to a photosensitive surface of a photosensitive chip of the circuit board assembly, a path is formed in the holder, and light passing through the optical system can reach the photosensitive surface through the path.

According to the foregoing technical solution, because the photosensitive apparatus includes the circuit board reinforcing structure according to this application, the photosensitive apparatus has all beneficial effect of the foregoing circuit board reinforcing structure, so that warping and deformation of a circuit board are suppressed. Therefore, it is ensured that the photosensitive apparatus reliably receives the light passing through the optical system.

In a possible implementation of the second aspect, the reinforcing plate and the holder are integrally formed.

According to the foregoing technical solution, a tolerance chain formed by manufacturing tolerances and assembly tolerances of components in the photosensitive apparatus can be shortened, so that an adverse impact of the tolerance chain on the photosensitive chip for receiving the light passing through the optical system is reduced.

In a possible implementation of the second aspect, the optical system includes a housing and a lens element, and the lens element is accommodated and disposed in the housing.

According to the foregoing technical solution, a solution of a typical optical system with a simple structure is provided.

In a possible implementation of the second aspect, the housing and the holder are integrally formed.

According to the foregoing technical solution, a tolerance chain formed by manufacturing tolerances and assembly tolerances of components in the photosensitive apparatus can also be shortened, so that an adverse impact of the tolerance chain on the photosensitive chip for receiving the light passing through the optical system is reduced.

In a possible implementation of the second aspect, the housing, the reinforcing plate, and the holder are integrally formed.

According to the foregoing technical solution, a tolerance chain formed by manufacturing tolerances and assembly tolerances of components in the photosensitive apparatus can be further shortened, so that an adverse impact of the tolerance chain on the photosensitive chip for receiving the light passing through the optical system is reduced.

In a possible implementation of the second aspect, the housing and the holder are separately manufactured, a flange part is disposed on the housing, and the flange part and a peripheral part of a first opening of the path are fastened to each other.

According to the foregoing technical solution, a reliable connection manner between a housing of a lens and the holder is provided when the optical system and the holder are separately manufactured.

In a possible implementation of the second aspect, the reinforcing plate and the holder are separately manufactured, and the reinforcing plate and a peripheral part of a second opening of the path are fastened to each other.

According to the foregoing technical solution, a reliable connection manner between the reinforcing plate and the holder is provided when the reinforcing plate and the holder are separately manufactured.

In a possible implementation of the second aspect, the reinforcing plate and the holder are fastened to each other by using an adhesive, and the adhesive is fully cured after active assembly.

According to the foregoing technical solution, when the reinforcing plate and the holder are not fully integrally formed, the photosensitive chip can be positioned to smoothly receive the light passing through the optical system.

In a possible implementation of the second aspect, the photosensitive apparatus is a lens module or a lidar apparatus.

According to the foregoing technical solution, an applicable scenario of the photosensitive apparatus in this application is provided.

According to a third aspect, an embodiment of this application provides a following terminal. The terminal includes the photosensitive apparatus according to any one of the foregoing technical solutions.

According to the foregoing technical solution, the photosensitive apparatus in this application can be used in terminals in different fields.

In a possible implementation of the third aspect, the terminal is a vehicle.

According to the foregoing technical solution, an optional solution of the terminal in this application is provided.

These aspects and other aspects of this application are more concise and more comprehensible in descriptions of the following (a plurality of) embodiments.

### BRIEF DESCRIPTION OF DRAWINGS

The accompanying drawings included in this specification and constituting a part of this specification and this specification jointly show example embodiments, features, and aspects of this application, and are intended to explain the principles of this application.
FIG. 1 is a schematic sectional view of a camera module;
FIG. 2A is a schematic top view of a circuit board reinforcing structure according to a first embodiment of this application;
FIG. 2B is a schematic sectional view of a circuit board reinforcing structure in FIG. 2A cut along a direction of A-A;
FIG. 3 is a schematic top view of a circuit board reinforcing structure according to a second embodiment of this application;
FIG. 4 is a schematic top view of a circuit board reinforcing structure according to a third embodiment of this application;
FIG. 5 is a schematic sectional view of a photosensitive apparatus according to a first embodiment of this application, where the photosensitive apparatus is a camera module and a section line is omitted;
FIG. 6 is a schematic sectional view of a photosensitive apparatus according to a second embodiment of this application, where the photosensitive apparatus is a camera module and a section line is omitted;
FIG. 7 is a schematic sectional view of a photosensitive apparatus according to a third embodiment of this application, where the photosensitive apparatus is a camera module and a section line is omitted; and
FIG. 8 is a schematic sectional view of a photosensitive apparatus according to a fourth embodiment of this application, where the photosensitive apparatus is a camera module and a section line is omitted.

### Descriptions of reference numerals:

10: flexible circuit board; 20: reinforcing plate; 30: photosensitive chip; 40: lens; 50: holder;
1: circuit board; 11: first surface; 12: second surface; 2: reinforcing plate; 2h: slot; 21: third surface; 22: fourth surface; 3: photosensitive chip; 4: lens; 41: housing body; 42: flange part; 5: holder;
T: thickness direction.

### DESCRIPTION OF EMBODIMENTS

The following describes various example embodiments, features, and aspects of this application in detail with reference to the accompanying drawings. Identical reference signs in the accompanying drawings represent elements that have same or similar functions. Although various aspects of embodiments are shown in the accompanying drawings, unless otherwise particularly specified, the accompanying drawings do not need to be drawn to scale.

The specific term "example" herein means "used as an example, embodiment or illustration". Any embodiment described as an "example" herein is not necessarily explained as being superior or better than other embodiments.

In addition, to better describe this application, numerous specific details are given in the following specific embodiments. A person skilled in the art should understand that this application can also be implemented without some specific details. In some examples, methods, means, and elements that are well-known to a person skilled in the art are not described in detail, so that the subject of this application is highlighted.

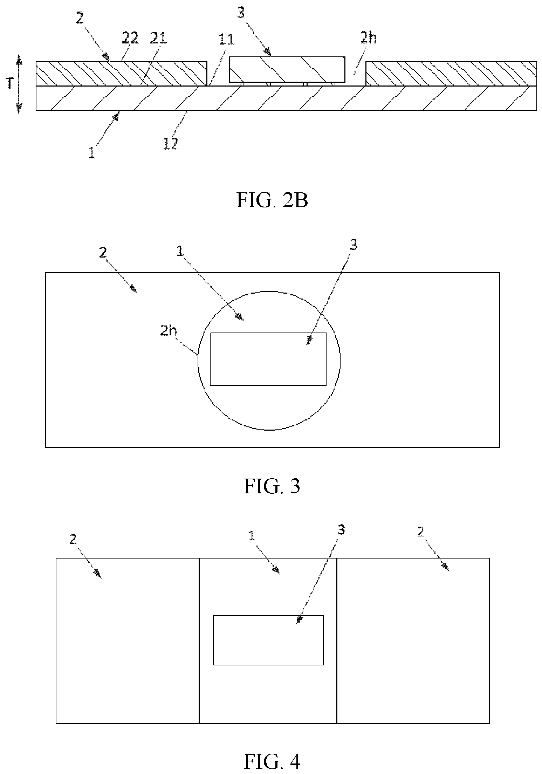

In this application, a "thickness direction" is a stacking direction of a circuit board, a photosensitive chip, and a reinforcing plate. Further, "one side in the thickness direction" is an upper side in FIG. 2B and FIG. 5 to FIG. 8, and "the other side in the thickness direction" is a lower side in FIG. 2B and FIG. 5 to FIG. 8.

The following describes a technical idea of this application. In a circuit board reinforcing structure in this application, a reinforcing plate of which deformation varies little with temperature is used to suppress warping and deformation of a circuit board caused by a temperature change, so that an impact of the warping and deformation of the circuit board on a location of a photosensitive chip is greatly reduced. In addition, the reinforcing plate and the photosensitive chip are disposed on a same side of the circuit board, so that when the circuit board reinforcing structure in this application is used in a photosensitive apparatus, a wire can be conveniently led out from the circuit board without disposing an additional structure for wiring on the reinforcing plate.

The following first describes a circuit board reinforcing structure according to a first embodiment of this application with reference to the accompanying drawings of the specification.

### (The circuit board reinforcing structure according to the first embodiment of this application)

As shown in FIG. 2A and FIG. 2B, the circuit board reinforcing structure according to the first embodiment of this application may be used in a circuit board assembly having a photosensitive component, to suppress warping and deformation of a circuit board of the circuit board assembly when a temperature changes.

In this embodiment, as shown in FIG. 2A and FIG. 2B, the circuit board assembly includes a circuit board 1 and a photosensitive chip 3. The circuit board 1 is a printed circuit board and is of a flat plate shape. The circuit board 1 has a first surface 11 located on one side in a thickness direction and a second surface 12 located on the other side in the thickness direction. The first surface 11 and the second surface 12 are opposite to each other and parallel to each other. The photosensitive chip 3 has a photosensitive surface and can receive light for imaging. The photosensitive chip 3 is disposed on the first surface 11 of the circuit board 1 and is electrically connected to the circuit board 1 through a solder joint.

In this embodiment, as shown in FIG. 2A and FIG. 2B, the circuit board reinforcing structure includes a reinforcing plate 2 made of metal. The reinforcing plate 2 is of a flat plate shape. The reinforcing plate 2 has a third surface 21 located on the other side in the thickness direction and a fourth surface 22 located on one side in the thickness direction. The third surface 21 and the fourth surface 22 are opposite to each other and parallel to each other. The reinforcing plate 2 is disposed on the first surface 11 of the circuit board 1. The reinforcing plate 2 and the circuit board 1 may be fastened to each other in the following manners: bonded to each other by using an adhesive, fastened by using a threaded connection member, fastened to each other by soldering, and fastened to each other in an integrally formed manner. When the reinforcing plate 2 and the circuit board 1 are fastened to each other, the third surface 21 of the reinforcing plate 2 and the first surface 11 of the circuit board 1 are always in surface contact. In addition, both the reinforcing plate 2 and the photosensitive chip 3 are located on one side of the first surface 11 of the circuit board 1. To be specific, both the reinforcing plate 2 and the photosensitive chip 3 are located on one side in the thickness direction relative to the circuit board 1.

In addition, to avoid that the first surface 11 of the circuit board 1 does not have enough area for arranging the photosensitive chip 3 because the reinforcing plate 2 is disposed, in this implementation, as shown in FIG. 2A, a slot 2h is provided on the reinforcing plate 2. In a top view observed in the thickness direction T, both a shape of the slot 2h and a shape of an outer contour of the photosensitive chip 3 are rectangular, and a size of the slot 2h is greater than a size of the outer contour of the photosensitive chip 3. In this way, the shape of the slot 2h is geometrically similar to the shape of the outer contour of the photosensitive chip 3. The photosensitive chip 3 is located in the slot 2h, and a geometric center of the photosensitive chip 3 coincides with a geometric center of the slot 2h. In this way, compared with a case in which the shape of the slot 2h is not geometrically similar to the shape of the outer contour of the photosensitive chip 3, a contact area between the circuit board 1 and the reinforcing plate 2 can be as large as possible. Therefore, a capability of the reinforcing plate 2 to suppress the warping and deformation is improved. In addition, the size of the slot 2h is greater than the size of the photosensitive chip 3, which helps position the photosensitive chip 3 in the slot 2h and prevent interference between the photosensitive chip 3 and the reinforcing plate 2.

According to the foregoing solution, the reinforcing plate 2 suppresses the warping and deformation of the circuit board 1 when the temperature changes, and after the circuit board reinforcing structure is disposed on the photosensitive apparatus, wiring can be conveniently performed on a lead wire of the circuit board 1 without disposing an additional wiring structure on the reinforcing plate 2. Therefore, the lead wire of the circuit board 1 can be led out to an outer side of the photosensitive apparatus.

The following describes a circuit board reinforcing structure according to a second embodiment of this application.

### (The circuit board reinforcing structure according to the second embodiment of this application)

As shown in FIG. 3, structures of the circuit board reinforcing structure according to the second embodiment of this application and the circuit board reinforcing structure according to the first embodiment of this application are basically the same. The following mainly describes differences between the circuit board reinforcing structure according to the second embodiment of this application and the circuit board reinforcing structure according to the first embodiment of this application.

As shown in FIG. 3, in this embodiment, a slot 2h is provided on a reinforcing plate 2. Different from the circuit board reinforcing structure according to the first embodiment, the slot 2h is of a circle shape. When a shape of a photosensitive chip 3 is rectangular, shapes of the slot 2h and the photosensitive chip 3 are not geometrically similar. The foregoing solution can also implement beneficial effect of suppressing warping and deformation of a circuit board 1 and facilitating wiring. In addition, an optional solution for implementing the circuit board reinforcing structure in this application is provided, so that the circuit board reinforcing structure can be used in different application scenarios. The circle herein is merely an example, and the shape of the slot 2h is not limited in this application.

The following describes a circuit board reinforcing structure according to a third embodiment of this application.

### (The circuit board reinforcing structure according to the third embodiment of this application)

As shown in FIG. 4, structures of the circuit board reinforcing structure according to the third embodiment of this application and the circuit board reinforcing structure according to the first embodiment of this application are basically the same. The following mainly describes differences between the circuit board reinforcing structure according to the third embodiment of this application and the circuit board reinforcing structure according to the first embodiment of this application.

As shown in FIG. 4, in this embodiment, two reinforcing plates 2 are disposed, and the two reinforcing plates 2 are disposed at spacings. A photosensitive chip 3 is located between the two reinforcing plates 2, and the photosensitive chip 3 is spaced from the two reinforcing plates 2. This solution can also implement beneficial effect of suppressing warping and deformation of a circuit board 1 and facilitating wiring. In addition, an optional solution for implementing the circuit board reinforcing structure in this application is provided, so that the circuit board reinforcing structure can be used in different application scenarios. In addition, as an exposed part that is of the circuit board 1 and that is between the two reinforcing plates 2 occupies a large area, another electronic component may further be arranged in addition to the photosensitive chip 3. This helps implement a more flexible structure and layout of a circuit board assembly.

The following describes a structure of a photosensitive apparatus according to a first embodiment of this application, where the photosensitive apparatus may include the circuit board reinforcing structure in the foregoing different embodiments.

### (The photosensitive apparatus according to the first embodiment of this application)

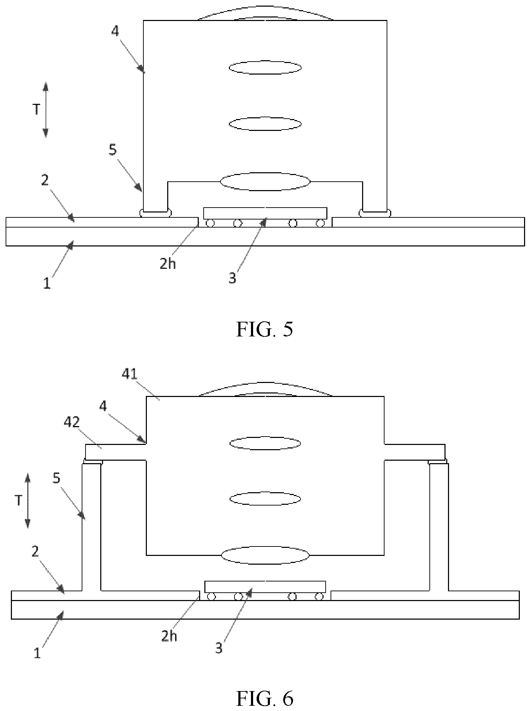

As shown in FIG. 5, the photosensitive apparatus according to the first embodiment of this application is a camera module. The photosensitive apparatus includes a circuit board assembly (including a circuit board 1 and a photosensitive chip 3), a reinforcing plate 2 (used as a circuit board reinforcing structure), a lens 4 (used as an optical system), and a holder 5. As described above, both the reinforcing plate 2 and the photosensitive chip 3 are disposed on the circuit board 1 and are located on a same side in a thickness direction T of the circuit board 1. Further, the reinforcing plate 2 and the holder 5 are fastened to each other by using an adhesive. The lens 4 includes a housing and a lens element. The lens element is accommodated and disposed in the housing, and the housing and the holder 5 are integrally formed, so that the lens 4 is fastened to the holder 5. In this way, the lens 4 and the holder 5 are located on one side in the thickness direction relative to the reinforcing member.

More specifically, in this embodiment, as shown in FIG. 5, a path is formed in the holder 5. An optical axis of the lens 4 is perpendicular to a photosensitive surface of the photosensitive chip 3 of the circuit board assembly, and light passing through the lens 4 can reach the photosensitive surface of the photosensitive chip 3 through the path. The housing of the lens 4 and a peripheral part of a first opening (on one side in the thickness direction) of the path of the holder 5 are fastened to each other. The reinforcing plate 2 and a peripheral part of a second opening (on the other side in the thickness direction) of the path of the holder 5 are fastened to each other by using the adhesive. After components of the photosensitive apparatus are disposed in place, an image surface of the lens 4 coincides with the photosensitive surface of the photosensitive chip 3, so that the photosensitive chip 3 can form a clear image.

According to the foregoing solution, because the photosensitive apparatus includes the circuit board reinforcing structure according to this application, the photosensitive apparatus has all beneficial effect of the foregoing circuit board reinforcing structure, thereby suppressing warping and deformation of the circuit board 1 caused by a temperature change. Therefore, it is ensured that the photosensitive surface of the photosensitive chip 3 always coincides with the image surface of the lens 4, and the temperature drift in the background is suppressed. In addition, because the housing of the lens 4 and the holder 5 are integrally formed, a tolerance chain formed by manufacturing tolerances and assembly tolerances of components in the photosensitive apparatus can also be shortened, so that an adverse impact of the tolerance chain on the photosensitive chip 3 for receiving the light passing through the lens 4 is reduced.

The following describes a structure of a photosensitive apparatus according to a second embodiment of this application, where the photosensitive apparatus may include the circuit board reinforcing structure in the foregoing different embodiments.

### (The photosensitive apparatus according to the second embodiment of this application)

As shown in FIG. 6, structures of the photosensitive apparatus according to the second embodiment of this application and the photosensitive apparatus according to the first embodiment of this application are basically the same. The following mainly describes differences between the photosensitive apparatus according to the second embodiment of this application and the photosensitive apparatus according to the first embodiment of this application.

As shown in FIG. 6, in this embodiment, a housing includes a housing body 41 and a flange part 42 that are integrally formed. A lens element is accommodated and disposed in the housing body 41. The flange part 42 extends from an outer peripheral surface of the housing body 41 to an outer side in a radial direction, and the flange part 42 continuously extends along a peripheral direction of the housing body 41 in the entire periphery.

To fasten the housing of the lens 4 and the holder 5 together, the flange part 42 and a peripheral part of a first opening (on one side in a thickness direction) of a path of the holder 5 are fastened to each other by using an adhesive. In addition, a reinforcing plate 2 and a peripheral part of a second opening (on the other side in the thickness direction) of the path of the holder 5 are fastened to each other. In this embodiment, the reinforcing plate 2 and the holder 5 may be integrally formed. In this way, same beneficial effect as those of the photosensitive apparatus in the first embodiment can be implemented.

The following describes a structure of a photosensitive apparatus according to a third embodiment of this application, where the photosensitive apparatus may include the circuit board reinforcing structure in the foregoing different embodiments.

### (The photosensitive apparatus according to the third embodiment of this application)

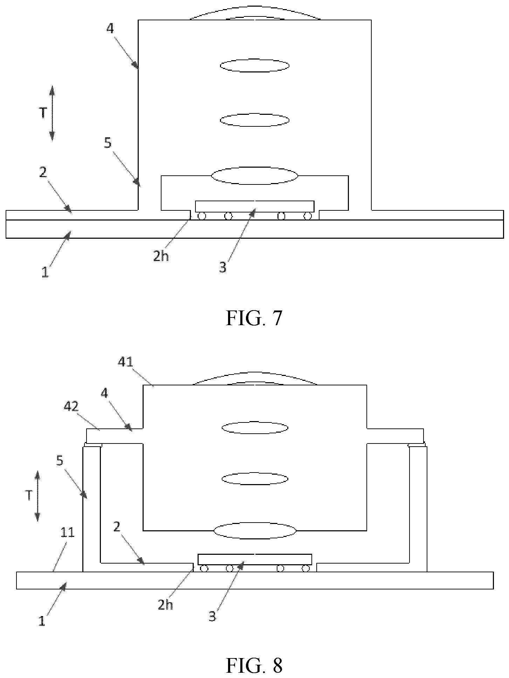

As shown in FIG. 7, structures of the photosensitive apparatus according to the third embodiment of this application and the photosensitive apparatus according to the first embodiment of this application are basically the same. The following mainly describes differences between the photosensitive apparatus according to the third embodiment of this application and the photosensitive apparatus according to the first embodiment of this application.

As shown in FIG. 7, in this embodiment, a housing of a lens 4, a reinforcing plate 2, and a holder 5 are integrally formed. In this way, in addition to implementing same beneficial effect as those of the photosensitive apparatus in the first embodiment, a tolerance chain formed by manufacturing tolerances and assembly tolerances of components in the photosensitive apparatus is further shortened, so that an adverse impact of the tolerance chain on the photosensitive chip 3 for receiving light passing through the lens 4 is reduced.

The following describes a structure of a photosensitive apparatus according to a fourth embodiment of this application, where the photosensitive apparatus may include the circuit board reinforcing structure in the foregoing different embodiments.

### (The photosensitive apparatus according to the fourth embodiment of this application)

As shown in FIG. 8, structures of the photosensitive apparatus according to the fourth embodiment of this application and the photosensitive apparatus according to the second embodiment of this application are basically the same. The following mainly describes differences between the photosensitive apparatus according to the fourth embodiment of this application and the photosensitive apparatus according to the second embodiment of this application.

As shown in FIG. 8, in this embodiment, a reinforcing plate 2 is located in a holder 5. In this way, a size of the reinforcing plate 2 is small, so that a circuit board 1 can reserve more parts for installing another electronic component. In this way, in addition to implementing same beneficial effects as those of the photosensitive apparatus in the second embodiment, a first surface 11 of the circuit board 1 can reserve enough installation space for installing another electronic component. This helps improve structural flexibility of the photosensitive apparatus.

The foregoing describes example embodiments and related variants of the specific implementations of this application, and the following provides supplementary descriptions.
i. In the foregoing embodiments, different embodiments and variants of the embodiments that can implement obj ectives of this application are described. It may be understood that, if there is no conflict, the solutions in these embodiments may be combined to form new solutions.
ii. In the photosensitive apparatus in this application, both a housing of a lens 4 and the holder 5 are rotation bodies that may have central axes. It may be understood that the housing of the lens 4 and the holder 5 are fastened together in a coaxial manner. In addition, in this application, the housing, the reinforcing plate 2, and the holder 5 may be mainly made of a same metal material.
iii. In embodiments of the photosensitive apparatus in this application, when any two of the circuit board 1, the lens 4, and the holder 5 are fastened to each other by using an adhesive, active assembly may be performed on the photosensitive apparatus. In other words, after the two components are preliminarily connected by using the adhesive, relative locations of the lens 4 and a photosensitive chip 3 are calibrated, so that an image surface of the lens 4 coincides with a photosensitive surface of the photosensitive chip 3, and then the adhesive is further cured. In implementation of the foregoing solution, the adhesive may be a two-phase curing adhesive. In the first phase, pre-curing may be performed by irradiating by an ultraviolet ray, and in the second phase, full curing may be performed by heating. In addition, in some optional solutions, the adhesive may be replaced by tin soldering or laser soldering.
iv. It may be understood that the reinforcing plate 2 is made of a single metal material, and therefore, a shape is very little affected by a temperature change. This helps suppress warping and deformation of the circuit board 1 when a temperature changes. In addition, the reinforcing plate 2 has a high thermal conductivity coefficient, which is conducive to heat dissipation of the circuit board 1, so that a temperature on the circuit board 1 is more uniform. In addition, it may be understood that a shape of an outer contour of the reinforcing plate 2 does not need to fully match a shape of an outer contour of the circuit board 1, and the reinforcing plate 2 having an outer contour of various shapes may be provided as required. The reinforcing plate 2 may be of a closed structure, or may be of a non-closed structure formed by a plurality of reinforcing plates. The foregoing embodiments are merely some examples of the reinforcing plate 2. The reinforcing plate 2 may also be of a structure of another shape, which is not limited herein.
v. It may be understood that, on the premise that it is ensured that installation of the photosensitive chip 3 is not affected, a smaller gap between the photosensitive chip 3 and the reinforcing plate 2 is better.
vi. The photosensitive apparatus in this application may not only be a camera module, but also be a lidar apparatus. In addition, this application further provides a terminal, and the terminal includes the photosensitive apparatus in this application. An optional solution of the terminal is a vehicle.

Although this application is described with reference to embodiments, in a process of implementing this application that claims protection, a person skilled in the art may understand and implement another variation of the disclosed embodiments by viewing the accompanying drawings, disclosed content, and the appended claims. In the claims, the word "comprising" does not exclude another component or another step, and "a" or "one" does not exclude a case of a plurality of objects. Some measures are recorded in dependent claims that are different from each other, but this does not mean that these measures cannot be combined to produce good effect.

The foregoing has described the embodiments of this application. The foregoing descriptions are examples, are not exhaustive, and are not limited to the disclosed embodiments. Many modifications and variations are apparent to a person of ordinary skill in the art without departing from the scope and spirit of the described embodiments. Selection of terms used in this specification is intended to best explain the principles of the embodiments, actual application, or improvements to technologies in the market, or to enable another person of ordinary skill in the art to understand the embodiments disclosed in this specification.

## Claims

1. A circuit board reinforcing structure, wherein the circuit board reinforcing structure is used in a circuit board assembly, the circuit board assembly comprises a circuit board and a photosensitive chip, the circuit board comprises a first surface and a second surface that are opposite to each other, and the photosensitive chip is disposed on the first surface of the circuit board and is electrically connected to the circuit board; and
the circuit board reinforcing structure comprises a reinforcing plate, the reinforcing plate comprises a third surface and a fourth surface that are opposite to each other, the reinforcing plate and the circuit board are fastened to each other, and the third surface and the first surface are in surface contact, so that both the reinforcing plate and the photosensitive chip are located on a side on which the first surface of the circuit board is located.

2. The circuit board reinforcing structure according to claim 1, wherein a slot is provided on the reinforcing plate, and the photosensitive chip is located in the slot.

3. The circuit board reinforcing structure according to claim 2, wherein a shape of the slot is geometrically similar to a shape of an outer contour of the photosensitive chip.

4. The circuit board reinforcing structure according to claim 3, wherein both the shape of the slot and the shape of the outer contour of the photosensitive chip are rectangular, and a size of the slot is greater than a size of the outer contour of the photosensitive chip, so that a gap exists between a periphery of the slot and the outer contour of the photosensitive chip.

5. The circuit board reinforcing structure according to any one of claims 1 to 4, wherein the reinforcing plate and the circuit board are fastened to each other in at least one of the following manners: bonded to each other by using an adhesive, fastened by using a threaded connection member, fastened to each other by soldering, and fastened to each other in an integrally formed manner.

6. The circuit board reinforcing structure according to any one of claims 1 to 4, wherein the photosensitive chip is electrically connected to the circuit board through a solder joint.

7. A photosensitive apparatus, wherein the photosensitive apparatus comprises the circuit board reinforcing structure according to any one of claims 1 to 6.

8. The photosensitive apparatus according to claim 7, wherein the photosensitive apparatus further comprises a circuit board assembly, a holder, and an optical system configured to collect light, the optical system and the reinforcing plate are fastened to the holder, an optical axis of the optical system is perpendicular to a photosensitive surface of a photosensitive chip of the circuit board assembly, a path is formed in the holder, and light passing through the optical system is capable of reaching the photosensitive surface through the path.

9. The photosensitive apparatus according to claim 8, wherein the reinforcing plate and the holder are integrally formed.

10. The photosensitive apparatus according to claim 8, wherein the optical system comprises a housing and a lens element, and the lens element is accommodated and disposed in the housing.

11. The photosensitive apparatus according to claim 10, wherein the housing and the holder are integrally formed.

12. The photosensitive apparatus according to claim 10, wherein the housing, the reinforcing plate, and the holder are integrally formed.

13. The photosensitive apparatus according to claim 10, wherein the housing and the holder are separately manufactured, a flange part is disposed on the housing, and the flange part and a peripheral part of a first opening of the path are fastened to each other.

14. The photosensitive apparatus according to claim 10, wherein the reinforcing plate and the holder are separately manufactured, and the reinforcing plate and a peripheral part of a second opening of the path are fastened to each other.

15. The photosensitive apparatus according to claim 14, wherein the reinforcing plate and the holder are fastened to each other by using an adhesive, and the adhesive is fully cured after active assembly.

16. The photosensitive apparatus according to any one of claims 8 to 15, wherein the photosensitive apparatus is a lens module or a lidar apparatus.

17. A terminal, wherein the terminal comprises the photosensitive apparatus according to any one of claims 7 to 16.

18. The terminal according to claim 17, wherein the terminal is a vehicle.
